(19)

**Europäisches Patentamt**

**European Patent Office**

**Office européen des brevets**

(11) **EP 4 660 642 A1**

(12) **EUROPEAN PATENT APPLICATION**

(43) Date of publication:
**10.12.2025 Bulletin 2025/50**

(21) Application number: **24305901.1**

(22) Date of filing: **07.06.2024**

(51) International Patent Classification (IPC):
**G01R 31/3185** *(2006.01)*    **G01R 31/3187** *(2006.01)*
**G01R 31/317** *(2006.01)*    **G06F 11/27** *(2006.01)*
**G06F 11/22** *(2006.01)*

(52) Cooperative Patent Classification (CPC):
**G01R 31/3187; G01R 31/31703; G01R 31/318566;
G06F 11/27**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP USA, Inc.
Austin TX 78735 (US)**

(72) Inventors:
 • **Desposito, Domenico
  31023 Toulouse (FR)**

 • **d'Esposito, Francesco
  31023 Toulouse (FR)**
 • **Schoegler, Werner
  5656 AG Eindhoven (NL)**
 • **Bosvieux, Tristan
  31023 Toulouse (FR)**
 • **Hafermalz, Markus
  5656 AG Eindhoven (NL)**

(74) Representative: **Schmütz, Christian Klaus
Johannes
NXP Semiconductors Germany GmbH
Intellectual Property Group
Beiersdorfstr. 12
22529 Hamburg (DE)**

(54) **ELECTRONIC CIRCUIT FOR PERFORMING A SELF-TEST**

(57) An electronic circuit for performing a self-test, comprising: a first circuit with: a first configuration register configured to define functions which are settable by a user, a first event processor, a first signal generator, and a first signature generator. The electronic circuit also comprises: a second circuit which comprises: a second configuration register configured to define the same functions, a second event processor, a second signal generator, and a second signature generator; and a comparison block. During a reference-defining mode of the electronic circuit: the first signal generator provides a checking signal to the first event processor, the first event processor generates an output signal based on the checking signal and the functions, and the first signature generator generates a reference signature based on this output signal. During a self-testing mode of the electronic circuit: the second signal generator provides the checking signal to the second event processor, the second event processor generates an output signal based on the checking signal and the functions, and the second signature generator generates a test signature based on this output signal. The comparison block compares the test signature to the reference signature to provide a test result signal.

Figure 6

EP 4 660 642 A1

# Figure 7

760

761

Customer saves the result key for a given configuration

762

Customer tests on different parts that the key is always the same

770

771

Time to time customer runs the test

772

Customer compares the key with the expected

Are different

774

Test signal indicates a failed test

Are the same

773

Test signal indicates a passed test

## Description

## Field

The present disclosure relates to an electronic circuit, and in particular to an electronic circuit that is suitable for performing a self-test. The electronic circuit can be used in a wide range of applications such as for breaking a fuse within an electric vehicle power module.

## Summary

According to a first aspect of the present disclosure, there is provided an electronic circuit for performing a self-test, the electronic circuit comprising:

a first circuit which comprises:

a first configuration register configured to define functions which are settable by a user,
a first event processor,
a first signal generator, and
a first signature generator;

a second circuit which comprises:

a second configuration register configured to define the same functions as the first configuration register,
a second event processor,
a second signal generator, and
a second signature generator; and

a comparison block;

wherein:

during a reference-defining mode of the electronic circuit:

the first signal generator is configured to provide a checking signal as an input signal to the first event processor,
the first event processor is configured to generate an output signal based on the checking signal and the functions defined by the first configuration register, and
the first signature generator is configured to generate a reference signature based on the output signal from the first event processor; and

during a self-testing mode of the electronic circuit:

the second signal generator is configured to provide the checking signal as an input signal to the second event processor,
the second event processor is configured to generate an output signal based on the checking signal and the functions defined by the second configuration register, and
the second signature generator is configured to generate a test signature based on the output signal from the second event processor; and

the comparison block is configured to compare the test signature to the reference signature in order to provide a test result signal.

In one or more embodiments, the electronic circuit comprises a common configuration register, wherein the common configuration register is configured to perform the functionality of both the first configuration register and the second configuration register, thereby defining the functions for both the first and second event processors.

In one or more embodiments, the electronic circuit comprises:

a common event processor configured to perform the functionality of both the first event processor and the second event processor;
a common signal generator configured to perform the functionality of both the first signal generator and the second signal generator; and
a common configuration register configured to perform the functionality of both the first signature generator and the second signature generator.

In one or more embodiments:

the second event processor is a different component to the first event processor;
the second signal generator is a different component to the first signal generator; and
the second signature generator is a different component to the first signature generator.

In one or more embodiments the reference-defining mode of the electronic circuit is implemented during a first time period and the self-testing mode of the electronic circuit is implemented during a second time period, wherein the second time period is after the first time period.

In one or more embodiments the reference-defining mode of the electronic circuit is implemented during a first time period, and the self-testing mode of the electronic circuit is implemented during a second time period, wherein the first time period overlaps with the second time period.

In one or more embodiments, the electronic circuit comprises a finite state machine configured to:

initiate the reference-defining mode of the electronic circuit by providing a reference-defining initiation signal to:
the first signal generator, the second signal generator, the first event processor, the second event processor, the first signature generator, and the second signature generator. And in one or more embodiments, the finite state machine is configured to:

initiate the self-testing mode of the electronic circuit by providing a self-testing initiation signal to:

the first signal generator, the second signal generator, the first event processor, the second event processor, the first signature generator, and the second signature generator.

In one or more embodiments, in response to receiving either: i) the reference-defining initiation signal, or ii) the self-test initiation signal, from the finite state machine:

the first signal generator, the second signal generator, the first event processor, the second event processor, the first signature generator, and the second signature generator are configured to be reset.

In one or more embodiments, the first signal generator and the second signal generator are configured to provide a pseudo-random checking signal, such that the pseudo-random checking signal is the same for each reference-setting mode of the electronic circuit and each self-test mode of the electronic circuit.

In one or more embodiments the finite state machine is configured to initiate a normal-operation mode of the electronic circuit by providing a normal-operation initiation signal after the reference-defining mode and / or the self-testing mode. In one or more embodiments, during a normal-operation mode of the electronic circuit:

the first signal generator is configured to operate as an input register configured to provide data-bus signals from a first data bus as input signals to the first event processor, and
the second signal generator is configured to operate as an input register configured to provide data-bus signals from a second data bus as input signals to the second event processor.

In one or more embodiments, the finite state machine is configured to provide a reference-defining initiation signal, a self-test initiation signal or a normal-operation initiation signal, based on a user input.

In one or more embodiments the electronic circuit further comprises a fuse; and a fuse-breaking circuit. In one or more embodiments, the test result signal is configured to indicate: i) a passed test if the test signature matches the reference signature; or ii) a failed test if the test signature does not match the reference signature. In one or more embodiments the electronic circuit is configured to take remedial action if the test result signal indicates a failed test.

In one or more embodiments, the fuse and the fuse-breaking circuit comprises a pyro-fuse.

In one or more embodiments, the electronic circuit is implemented on an integrated circuit.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

**Brief Description of the Drawings**

One or more embodiments will now be described by way of example only with reference to the accompanying drawings in which:

Figures 1a-1c show an example pyro-fuse for use within an electric vehicle, which may be used in combination with an electronic circuit described in this disclosure;
Figure 2 shows one way of implementing an LBIST. In this example, the LBIST circuitry is separate to the fuse-control circuit;
Figure 3 shows one way of implementing a fuse-control circuit;
Figure 4 shows an example fuse-control circuit, which has been modified to comply with safety regulations, such as ASIL;
Figure 5 shows an electronic circuit which includes a fuse-control circuit and an LBIST circuit;
Figure 6 shows an electronic circuit for performing a self-test, according to an embodiment of the present disclosure; and
Figure 7 shows a method for performing a self-test, according to an embodiment of the present disclosure.

**Detailed Description**

The safety of a complex digital block can be checked by the use of a self-test. One such example of a self-test is a logic built-in self-test (LBIST). The use of a self-test allows the complex digital block to find issues sooner than would otherwise be possible, for example if the complex digital block was instead tested externally outside of the standard use case. The self-test can be implemented within a complex digital block by introducing a large number of additional components which occupy space and increase the complexity of the block.

Some self-test implementations may greatly increase the power consumption of the complex digital block.

The electronic circuit described in this disclosure may be used within a wide variety of different applications and contexts. In fact, the electronic circuit described within this disclosure may be used with any digital block which has a similar existing architecture. For the sake of understanding, the various embodiments described below will mostly be discussed in relation to an implementation within an electric vehicle with a large battery pack, wherein the electronic circuit is suitable for performing an LBIST. In these examples, the result of the LBIST can be used to guarantee the functional integrity of a logic circuit (EVM) that is used to break a pyro-fuse to disconnect the battery pack from the vehicle.

The electrification of vehicles imposes the usage of bigger battery packs which provide more energy and faster current peaks due to lower impedance within the battery packs. This can create a risk of thermal runaway and, therefore, some electronics are needed to protect people against this risk. One such method of protecting people against this risk it to use a pyro-fuse.

For example, a Battery junction box monitoring and switching (BJBMS) circuit may be used, which uses an LBIST test to ensure the integrity and correct function of a logic circuit (EVM) that is used to drive a pyro-fuse which can disconnect the battery pack from the vehicle if an error condition is detected. This activation of the pyro-fuse is a critical safety function that may be constrained by many requirements and / or regulations. For example, the electric vehicle may be required to conform to one or more automotive safety integrity levels (ASILs).

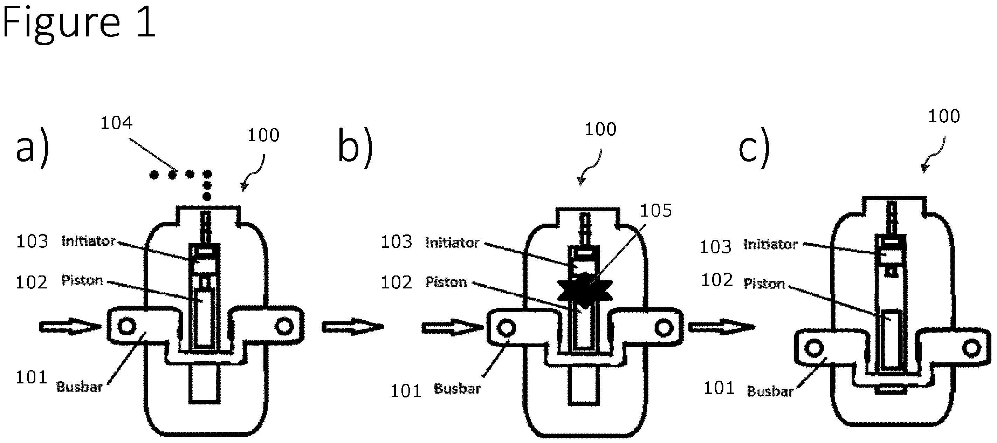

Figures 1a-1c show an example pyro-fuse 100 for use within an electric vehicle, which may be used in combination with the electronic circuits described in this disclosure. The pyro-fuse 100 includes a busbar 101, a piston 102 and an initiator 103.

Figure 1a shows the pyro-fuse 100 in the normal state. In this state, the busbar 101 provides an electrical connection between the battery pack (not shown) and other vehicle components (not shown). The busbar 101 communicates power from the battery pack to the other vehicle components. If the result of an EVM decision logic indicates that an error is present in the vehicle, an ignition current 104 is generated and provided to the initiator 103. The LBIST guarantees the correct function of the decision-making logic circuit (EVM). If this LBIST finds an error of the circuit, a diagnostic message is provided and appropriate remedial actions can be taken.

Figure 1b shows the pyro-fuse 100 immediately after receiving the ignition current 104. After receiving the ignition current 104, the initiator 103 ignites a flammable gas 105. As will be described with reference to Figure 1c, the ignition of this gas 105 exerts a force on the piston 102.

Figure 1c shows the pyro-fuse 100 after the ignition operated gas emission of Figure 1b. The force exerted on the piston 102 by the gas 105 causes a displacement of the piston 102. This displacement of the pressurised piston 102 breaks the busbar 101, thereby shutting down the electric vehicle system.

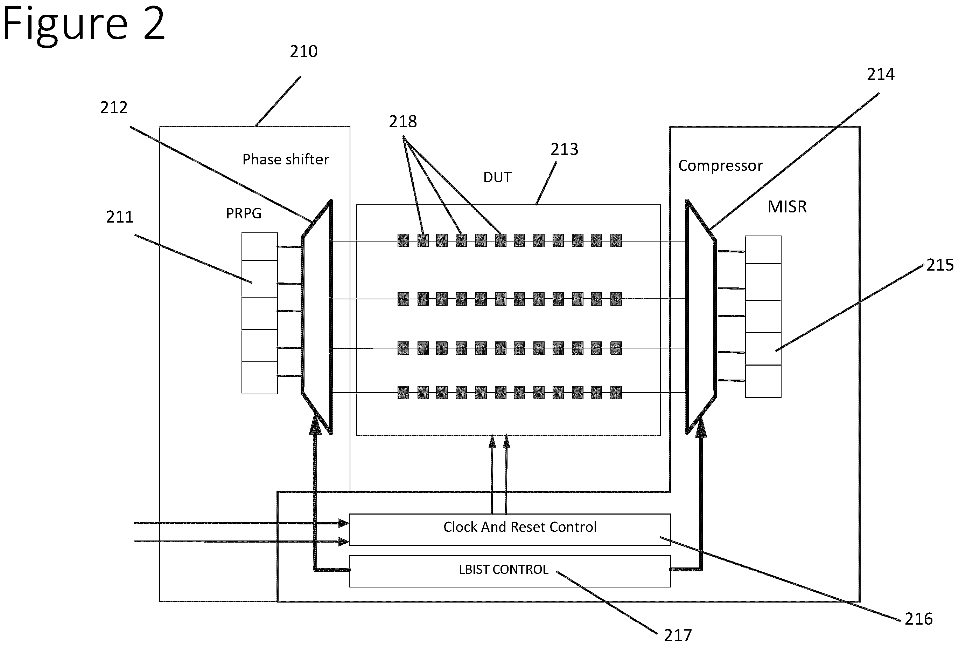

Figure 2 shows one way for implementing an LBIST. In this example, the LBIST circuitry 210 is for testing a device under test (DUT) 213, and is separate to the fuse-control circuit. The LBIST circuitry 210 may include a pseudo random pattern generator (PRPG) 211, a phase shifter 212, a compressor 214, a multi-input shift register (MISR) 215, a clock and reset control block 216 and an LBIST control block 217. The DUT 213 includes a plurality of rows of flops 218.

In this example, the LBIST circuitry 210 first takes control of all of the flops 218 on the DUT 213. Then, the LBIST circuitry 210 configures all of the DUT flops 218 with a known value.

One of implementing a LBIST is the insertion of additional DFT [design for test] structures during the synthesis of the DUT 213 for proving the integrity of what has been implemented. The LBIST charges all the flops 218 of the DUT with a known value and executes the designed function on those inputs.

$$Out = F(\text{inputs})$$

The output values are then shifted out, compressed and compared with an expected value.

This approach has the advantage of generating a mathematical result of the coverage of the DUT 213 but has the disadvantage of increasing the maximum power consumption during the charge of the flops 218, increasing the die size and the complexity of the digital flow. In addition it can also increase the required maximum current of a digital supply regulator, which increases the silicon area and silicon cost for this block. Furthermore, it can also require a full reset of the DUT 213 at the end of the LBIST execution, thereby generating a big overhead for the customer that has to reprogram the blocks. Embodiments of the present disclosure can address and solve one or more of those disadvantages.

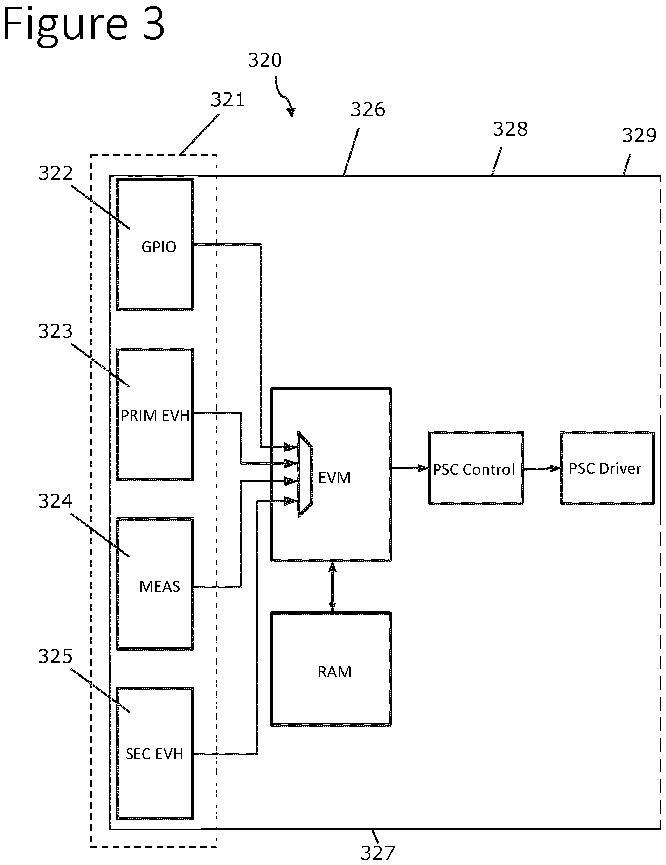

Figure 3 shows one way of implementing a fuse-control circuit 320. In this example, the fuse-control circuit includes a plurality of input sensors 321. The plurality of input sensors may include general purpose input-output (GPIO) sensors 322, primary event handling (PRIM EVH) sensors 323, a measurement block (MEAS) 324, secondary event handling (SEC EVH) sensors 325 and / or any other type of input sensor.

In this example, the fuse-control circuit also includes an event management (EVM) unit 326 which is configured to receive input signals from the plurality of input sensors 321. The fuse-control circuit in Figure 3 also includes a random-access memory (RAM) block 327 which contains functions that are settable by a user. The RAM block 327 may include a configuration register. In this example, the EVM unit 326 processes the data sensed by the plurality of input sensors 321, using user-defined functions from the RAM block 327, in order to provide output signals. It can therefore be said that the EVM unit 326 implements configurable logic blocks which make the decision as to whether or not to activate the fuse.

In this example, the fuse-control circuit is configured to control a pyro-fuse, such as the one described above with reference to Figure 1. As such, the fuse-control circuit may include a pyro-switch controller (PSC Control) block 328 and a pyro-switch driver (PSC Driver) block 329. The PSC Control block 328 receives the output signals from the EVM unit 326 and uses the output signals to control the PSC Driver block 329. Under the control of the PSC Control block 328, the PSC Driver block 329 drives the operation of the pyro-fuse. That is, the PSC Driver block 329 generates the ignition current which triggers the ignition operated gas emission that displaces the piston and detaches the busbar, as described above with reference to Figure 1.

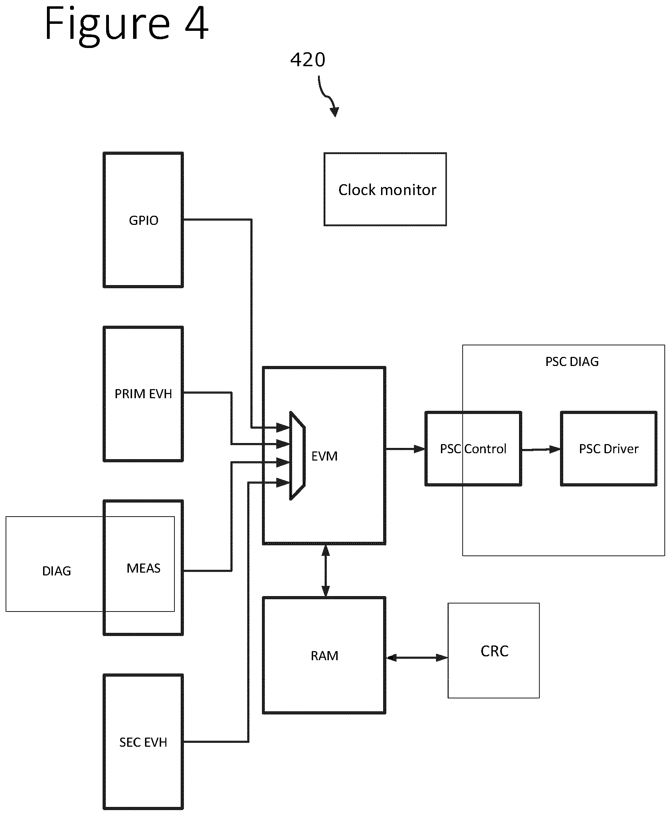

Figure 4 shows an example fuse-control circuit 420, which has been modified to comply with safety regulations, such as ASIL. The fuse-control circuit 420 is mostly the same as the fuse-control circuit shown in Figure 3, but with the addition of some safety mechanisms. These safety mechanisms are implemented to control both single-point and multiple-point failures within the system.

The fuse-control circuit (EVM) 420 may include a programmable decision logic to react on events coming from various monitoring functions (clock, voltage, temperature, etc.). Parameters and functions are configurable either in registers or in a RAM block, or a combination of both. The integrity of these parameters can be tested by cyclic redundancy check (CRC) functions. The fuse-control circuit 420 may also include any other relevant safety mechanisms in order to improve user safety or to comply with any safety regulations.

In other examples, the fuse-control circuit and the LBIST circuit can be applied on a single complex digital block, which needs to be tested for its effectiveness to detect failures using an LBIST. The LBIST in use can be based on 3 steps:

i) isolate the device under test,
ii) provide a checking signal, and
iii) check if the outputs are as expected.

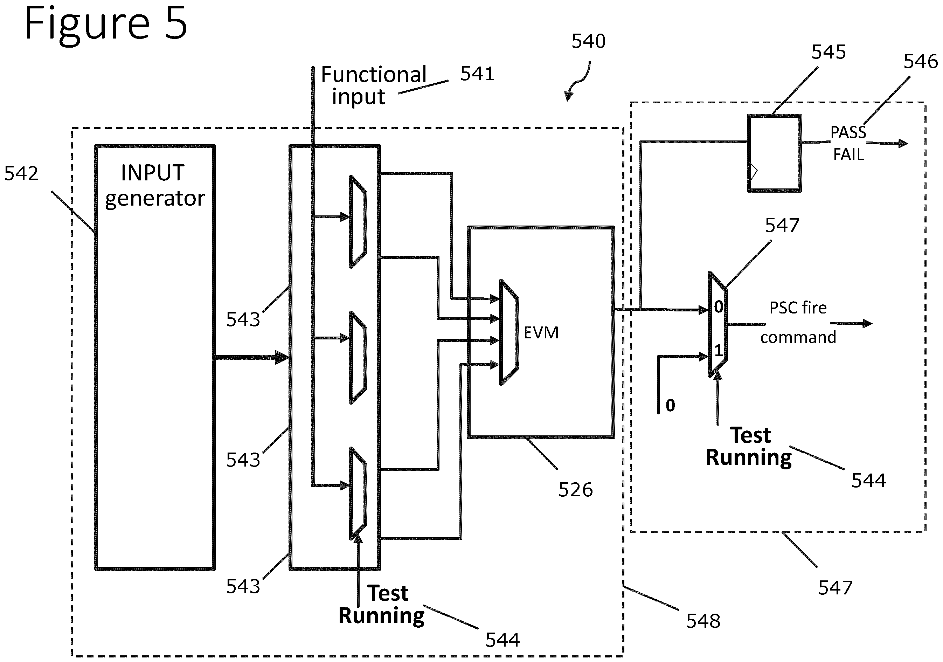

Figure 5 shows an electronic circuit 540 which includes a fuse-control circuit 547 and an LBIST circuit 548. The electronic circuit 540 includes an EVM block 526 configured to receive sensed input signals 541 (shown in the figure as "Functional input") from one or more input sensors (not shown).

In this example, the electronic circuit 540 also includes a signal generator 542 (shown in the figure as "INPUT generator") configured to provide a checking signal to the EVM block. The checking signal is known but it does not carry any information. That is, the checking signal is an arbitrary signal which is not dependent on any sensed input or other data, and the checking signal is the same for each execution run of the LBIST.

The electronic circuit 540 may include one or more multiplexers 543 configured to select either the sensed input signals 541 or the checking signal generated by the signal generator 542 based on the state of an LBIST signal 544 (shown in the figure as "Test Running signal").

In this example, the electronic circuit 540 can operate in either: i) a normal-operation mode, in which the sensed input signals 541 are provided to the EVM unit 526, or ii) an LBIST mode, in which the checking signal is provided to the EVM unit 526.

The LBIST signal 544 has a first value if the electronic circuit 540 is in the LBIST mode and a second value if the electronic circuit 540 is in the normal-operation mode. The LBIST signal 544 is provided to the one or more multiplexers 543. When the LBIST signal 544 has the first value (that is, when the electronic circuit is in the LBIST mode), the checking signal generated by the signal generator 542 is provided to the EVM block. When the LBIST signal 544 has the second value (that is, when the electronic circuit is in the normal-operation mode), the sensed input signals 541 are provided to the EVM unit 526. In this way, the device under test (the EVM unit 526) is isolated during the LBIST mode.

As above, in the example fuse-control circuits described with reference to Figures 3 and 4, the EVM unit 526 is configured to process the signals it receives as input signals, irrespective of whether the input signals are sensed input signals 541 or the checking signal, to provide output signals. In this example, the EVM unit 526 includes a configuration register (not shown) which defines functions for use by the EVM unit 526 for processing the input signals. The functions defined by the configuration register are settable by a user, and they are intended to be stable such that they do not change based on the mode of the electronic circuit 540. Because the checking signal is the same for each LBIST, and the functions used by the EVM unit 526 do not change, the output signals provided by the EVM unit 526 based on the checking signal are predictable. That is, the EVM unit 526 output signals, based on the checking signal, are the same for each LBIST when there are no errors present.

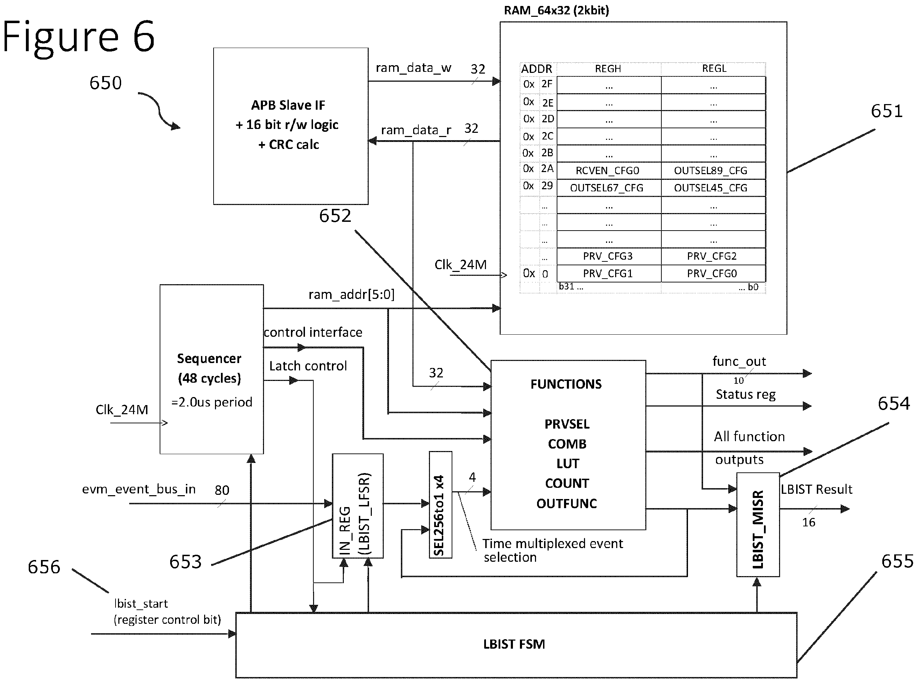

At the end of an execution of the LBIST run, as will be discussed in detail with reference to Figure 6, a signature value is calculated which can be compared to an expected signature value in order to generate the required LBIST pass / fail information. The electronic circuit 540 of Figure 5 also includes a block 545 that provides a test result signal 546 that indicates if the test has failed or passed. The test result signal 546 may indicate a passed test if the generated signature matches the expected signature, and the test result signal 546 may indicate a failed test if the generated signature does not match the expected signature. The LBIST test result can be passed to the application software to further react on a failed LBIST diagnostic. Such a reaction can be in various ways. In any case, the target can be to put the overall system in a fail-safe-mode with reduced performance, e.g. to be able to drive to next service station.

In this example, the electronic circuit 540 also includes a PSC isolation multiplexer 547 with an output terminal connected to the PSC Control and / or PSC Driver blocks (not shown). The PSC isolation multiplexer 547 is configured to select between the output signals from the EVM unit 526 and a logic low signal (e.g., a 0V signal as shown in Figure 5), based on the state of the LBIST signal 544. When the LBIST signal 544 has the second value (that is, when the electronic circuit is in the normal-operation mode), the output of the PSC isolation multiplexer 547 is the logic low signal such that the PSC Control and / or the PSC Driver blocks do not break the pyro-fuse in response to the output signals of the EVM unit 526. When the LBIST signal 544 has the first value (that is, when the electronic circuit is in the LBIST mode), the output signals from the EVM unit 526 are provided to the PSC Control and / or the PSC Driver blocks such that pyro-fuse can be broken in response to an error being detected.

It will be appreciated that the electronic circuits described in this disclosure can be used within any suitable applications. As such, the electronic circuits are not limited to the purpose of breaking a fuse upon the detection of an error, this is merely an illustrative example. The test result signal produced by the self-test may be used for any other appropriate purpose. This is especially true because the user can define any functions within the configuration register.

Figure 6 shows an electronic circuit 650 for performing a self-test, according to an embodiment of the present disclosure. The electronic circuit 650 includes a configuration register 651 configured to define functions which are settable by a user.

The configuration register 651 is implemented in a RAM block, but it could also be implemented using any other relevant technology, such as a flash block. The electronic circuit also includes an event processor 652 (shown in the figure as "FUNCTIONS"), a signal generator 653 (shown in the figure as "IN_REG (LBIST_LFSR)", where IN_REG is shorthand for input register and LFSR is an acronym for linear feedback shift register), and a signature generator 654 (shown in the figure as "LBIST_MISR", where MISR is an acronym for multi input shift register).

As will be discussed below, the electronic circuit 650 can include either one set of the above-described components (that is, the configuration register 651, the event processor 652, the signal generator 653 and the signature generator 654), or two sets of the above-described components. Redundant implementations, i.e. those with two sets of the above-described components, can be used to fulfil ASIL functional safety requirements. In examples, which include two sets of the above-described components, both sets of components work in the same way as each other. For the sake of understanding, the embodiment with only one set of the above-described components will be discussed at first, but it will be understood that this description explains both sets of the above-described components (if applicable).

The signature generator 654 generates a signature based on output signals received from the event processor 652. The signature generator 654 can process output signals that have been generated by the event processor 652 during a present self-test mode of the electronic circuit 650; e.g., all of the output signals that are generated in response to a checking signal during each LBIST run.

The electronic circuit 650 is configured to operate in a reference-defining mode and a self-testing mode, as well as in a normal-operation mode. During the reference-defining mode, the signal generator 653 provides a checking signal as an input signal to the event processor 652, as above. The event processor 652 generates an output signal based on the checking signal and the functions defined by the configuration register 651. The output signals (with 16 points in this example) may be continually latched to create a sequence of 16-bit vectors. The signature generator 654 thereby generates a reference signature based on the output signal from the event processor 652, whereby the output signal was generated as a result of processing the checking signal as its input signal. In this example, the signature generator 654 is a 16-bit multi-input shift register, although any other suitable signature generator 654 may be used. The shift register in this example combines the previous states of the output signals that were produced as a result of processing the checking signal in order. In this way, the reference signature is based on the output signals of the event processor during the execution of the self-test. Nonetheless, it will be appreciated that any other suitable signature generation method may be used.

As described above with reference to Figure 5, the checking signal is the same for each self-test, including the test which is performed during the reference-defining mode. The functions within the configuration register 651 are also the same for each self-test, and indeed they are not expected to change during the normal-operating mode of the electronic circuit 650 either. Therefore, the reference signature generated during the reference-defining mode is the expected output signature for all future self-tests. The reference signature may be stored in any suitable manner. For example, it can be stored by the electronic circuit 650 or it can be stored by a different device or circuit that is connected to the electronic circuit 650.

In examples where the functions within the configuration register 651 are not changed at any time in any of the modes of the electronic circuit 650, time and energy can be saved by eliminating the need to configure and reconfigure any components to perform a self-test. Advantageously, this allows the electronic circuit 650 to perform a self-test with a reduced impact on the user, when compared to alternative architectures.

Advantageously, the functionality that is described above generates a reference signature that is bespoke for the specific functions that have been set by the user and stored within the configuration register 651. This means that the electronic circuit 650 may be used to test the functionality of the event processor 652 irrespective of the way in which a user has configured the functions in the configuration register 651 without requiring any additional modifications to the circuit or configuration register 651.

In some examples, the user may wish to change the functions that they have set in the configuration register 651, for example to provide updates to their application or to repurpose the electronic circuit 650. If the user does this, then the reference-defining mode can be repeated in order to generate a new reference signature which is based on the updated functions in the configuration register. This functionality, especially when combined with the advantages described above, contributes to the flexibility of the electronic circuit 650.

The electronic circuit 650 is put into a self-testing mode of operation either during, or after, the reference-defining mode. As will be discussed in detail below. The electronic circuit 650 generates a test signature when it is in the self-testing mode. Any differences between the test signature and the reference signature (that is generated in the reference-defining mode) can be indicative of a fault in the device under test.

When in the self-testing mode, the signal generator 653 provides the checking signal as an input signal to the event processor 652. The event processor 652 is configured to generate an output signal based on the checking signal and the functions defined by the configuration register 651. The signature generator 654 then generates a test signature based on the sequence of output signal states from the event processor 652.

In some examples, the electronic circuit 650 also includes a comparison block (not shown) which is configured to compare the test signature to the reference signature in order to provide a test result signal. In such an example, a register can be used to store the expected value such that the comparison can be performed in hardware, and such that the hardware can provide the test result signal to software. The software can then initiate any remedial action that may be required if the test fails. In other examples, software can be used to compare the test signature to the reference signature in order to provide the test result signal. Either way, the test result signal can indicate: i) a passed test if the test signature matches the reference signature; or ii) a failed test if the test signature does not match the reference signature.

In some embodiments, the electronic circuit is implemented on an integrated circuit.

In some embodiments, the same components of the electronic circuit 650 can be used to generate the reference signature in the reference-defining mode and to generate the test signature in the self-testing mode. In which case, the self-testing mode occurs after the reference-defining mode has been completed.

As mentioned above, in other embodiments, the electronic circuit 650 can include two sets of components - one for generating the reference signature in the reference-defining mode, and the other for generating the test signature in the self-testing mode. In which case, the self-testing mode and the reference-defining mode can occur at the same time, or the self-testing mode can occur after the reference-defining mode. Therefore, the electronic circuit 650 includes a first circuit and second circuit. The first circuit includes: a first configuration register configured to define functions which are settable by a user, a first event processor, a first signal generator, and a first signature generator. The second circuit includes: a second configuration register configured to define the same functions as the first configuration register, a second event processor, a second signal generator, and a second signature generator. It follows therefore, that in some embodiments, the components that are referred to as a first one are different to the corresponding components that are referred to as a second one. In other embodiments, the components that are referred to as a first one are the same as the corresponding components that are referred to as a second one.

During a reference-defining mode of the electronic circuit 650: the first signal generator provides a checking signal as an input signal to the first event processor. The first event processor generates an output signal based on the checking signal and the functions defined by the first configuration register, and the first signature generator generates a reference signature based on the output signal from the first event processor. During a self-testing mode of the electronic circuit 650: the second signal generator provides the checking signal as an input signal to the second event processor. The second event processor generates an output signal based on the checking signal and the functions defined by the second configuration register, and the second signature generator generates a test signature based on the output signal from the second event processor. In this way: i) the second event processor may be a different component to the first event processor, ii) the second signal generator may be a different component to the first signal generator, and iii) the second signature generator may be a different component to the first signature generator. Advantageously, the second circuit provides redundancy for the first circuit.

In the embodiments where the electronic circuit 650 uses the same components to generate the reference signature and the test signature, the electronic circuit 650 may include a common configuration register, wherein the common configuration register is configured to perform the functionality of both the first configuration register and the second configuration register, thereby defining the functions for both the first and second event processors. The electronic circuit 650 may also include: i) a common event processor configured to perform the functionality of both the first event processor and the second event processor, ii) a common signal generator configured to perform the functionality of both the first signal generator and the second signal generator, and iii) a common configuration register configured to perform the functionality of both the first signature generator and the second signature generator.

In the embodiments where the first and second circuits are implemented by the same, common, components, the reference-defining mode of the electronic circuit 650 may be implemented during a first time period, and the self-testing mode of the electronic circuit may be implemented during a second time period, wherein the first time period overlaps with the second time period. That is, the self-testing mode for one circuit begins before the reference signature is generated by the other circuit. In some examples, the first time period and the second time period may overlap completely. In these examples, the signatures produced by the first circuit and the second circuit may be compared to each other, instead of being compared to a previously generated reference signature. Here, the signature generated by the first circuit can be considered a reference signature and the signature generated by the second circuit can be considered a test signature, or *vice versa.*

In any embodiment, the reference-defining mode of the electronic circuit 650 may be implemented during a first time period and the self-testing mode of the electronic circuit 650 may be implemented during a second time period, wherein the second time period is after the first time period. That is, the self-testing mode begins only after the reference signature has been generated upon completion of the reference-defining mode.

Returning to Figure 6, the electronic circuit 650 in this example includes a finite state machine (FSM) 655. The FSM initiates the reference-defining mode of the electronic circuit 650 by providing a reference-defining initiation signal to: the signal generator 653, the event processor 652, and the signature generator 654. The finite state machine 655 also initiates the self-testing mode of the electronic circuit by providing a self-testing initiation signal to: the signal generator 653, the event processor 652, and the signature generator 654.

In response to receiving either: i) the reference-defining initiation signal, or ii) the self-test initiation signal, from the finite state machine 655: the signal generator 653, the event processor 652, and the signature generator 654 in this example are reset. That is, any values, signals or signatures that are stored in associated registers (including any input register associated with the signal generator 653, and any linear feedback shift register associated with the signature generator 654) are deleted. Also, the values of any variables which may be in use by the event processor 652 are reset.

The signal generator 653 in this example provides a pseudo-random checking signal, which can be a cyclically repeating signal. In the embodiments wherein the signal generator 653 is reset upon receipt of a reference-defining initiation signal or a self-test initiation signal, the pseudo-random checking signal is the same each time after: i) the first signal generator is reset, and ii) the second signal generator is reset.

Such a pseudo-random checking signal can be generated by applying a function to an initial seed, which is the same for each instance of a reference-defining mode and a self-test mode such that the pseudo-random checking signal is always the same sequence.

In other embodiments, the checking signal may be generated by any suitable method. For example, the checking signal may be a predetermined signal which is retrieved from memory by the signal generator 653.

In the example of Figure 6, the finite state machine 655 initiates a normal-operation mode of the electronic circuit 650 by providing a normal-operation initiation signal after the reference-defining mode and / or the self-testing mode. In these embodiments, the normal-operation initiation signal is provided to: the signal generator 653, the event processor 652, and the signature generator 654. During a normal-operation mode of the electronic circuit 650, the event processor 652 applies the functions defined by the configuration register 651 to input signals derived from one or more input sensors (not shown). These input signals are labelled as evm_event_bus_in in Figure 6.

During a normal-operation mode of the electronic circuit: the signal generator 653 can operate as an input register (IN_REG) that receives data-bus signals and provides them as input signals to the event processor 653. Advantageously, this reduces the number of additional components required to implement the self-test functionality that is described herein. In embodiments where the electronic circuit is implemented on an IC, this reduction of the number of additional components can reduce the complexity of the overall circuit, the area of the die that is required to implement the self-test functionality, and it can also reduce the power consumption of the electronic circuit when compared to alternative self-test capable circuits.

In this embodiment, in response to receiving the normal-operation initiation signal from the finite state machine 655: the signal generator 653, the event processor 652, and the signature generator 654 can be reset. Here, the word "reset" is to be interpreted in the same way as explained above.

In some embodiments, the finite state machine 655 is configured to provide one or more of the reference-defining initiation signal, the self-test initiation signal and the normal-operation initiation signal, based on a user input 656. In other embodiments, the finite state machine 655 is configured to provide one or more of the reference-defining initiation signal, the self-test initiation signal and the normal-operation initiation signal, based on any other suitable trigger. For example, the finite state machine 655 may provide self-test initiation signals at regular intervals. The finite state machine 655 may provide normal-operation initiation signals in response to a test result signal which indicates a passed test. The finite state machine 655 may provide a reference-defining initiation signal after the functions defined by the configuration register 651 have been set by a user.

Advantageously, in order to perform a self-test, examples of the electronic circuits 650 that are described herein may not require any additional complex steps in the synthesis flow using scripts or external tools. The electronic circuit 650 can focus the coverage of the self-test on the portion of the device under test that is actively participating in the generation of output signals (in this case the event processor 652) with very limited extra power consumption, die size and complexity.

The activity rates of logic gates within the event processor 652 under test are very close to the activity rates which may be used for the normal application of the electronic circuit 650; that is, when the electronic circuit 650 is not in a reference-defining mode or a self-test mode. This means that the power consumption of the electronic circuit 650 during a reference-defining mode or a self-test mode is not increased when compared to the electronic circuit 650 when it is not in either of these modes. A further advantage of an electronic circuit 650 according to the present disclosure is that performing a self-test does not impact the configuration that has been set by the user (as defined by the configuration register 651). This means that no additional time and energy is used to update and / or reset the functions within the configuration register 651. The self-test performed by the electronic circuit 650 can cover all of the logic gates which are used inside the specific configuration required by the user, and the self-test can also activate the corresponding outputs.

The embodiments discussed above can provide a number of advantages over existing self-test circuits which are suitable for performing a self-test, including one or more of:

    i) the self-test circuitry does not increase the complexity of the electronic circuit;
    ii) the self-test circuitry does not significantly increase the power consumption of the electronic circuit (which may otherwise have increased above the capability of a digital voltage regulator);
    iii) the self-test circuitry does not occupy additional die space (except in examples which include a finite state machine, in which case the additional space required remains less than may be required by other solutions), and therefore does not (greatly) increase the die size requirements of the electronic circuit; and
    iv) the configuration register(s) need not be reprogrammed by the user at each new execution of the self-test.

In the preceding advantages, the "self-test circuitry" refers to the components used to perform the self-test (that is, the first and second configuration registers, event processors, signal generators, signature generators and the finite state machine - if applicable). Advantages (i)-(iii) are discussed in comparison to an electronic circuit which is suitable for performing the same role within its normal mode of operation, without the ability to perform a self-test. Advantage (iv) improves the flexibility of the electronic circuit, allowing self-tests to be performed 'in the field' which can save time and resources, whilst eliminating the possibility of mistakes being introduced during reprogramming.

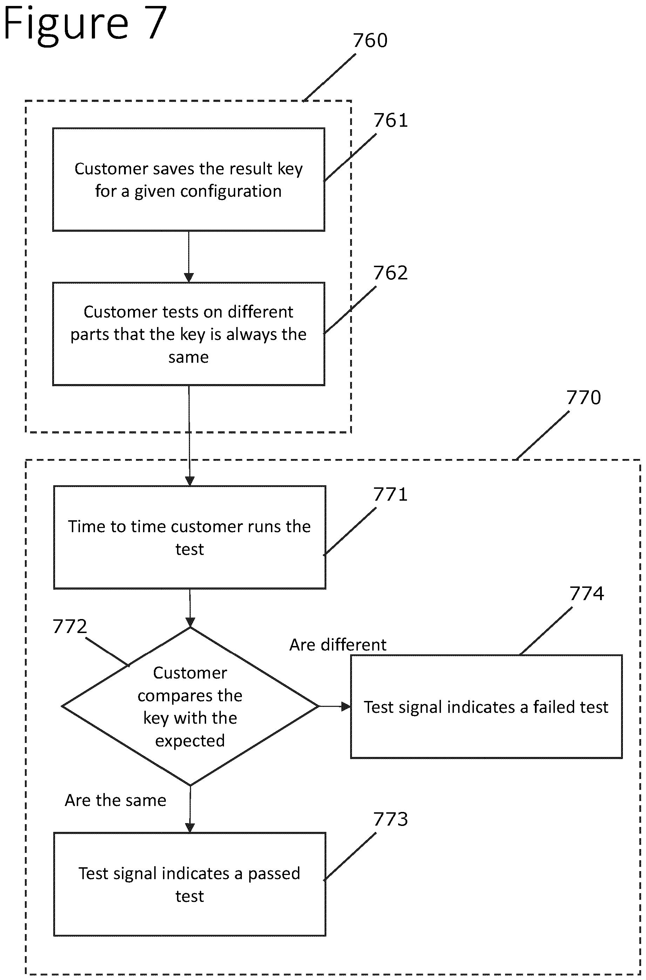

Figure 7 shows a method for performing a self-test, according to an embodiment of the present disclosure. The method steps located within box 760 (steps 761 and 762) may be performed by the user in a lab, before the system is in active use. The method steps located within box 770 (steps 771 - 774) may be performed anywhere, while the system is in active use.

After the user has set the functions within the configuration register, at step 761, the user (referred to as "Customer" in the figure) saves the reference signature (referred to as "result key" in the figure) for the current configuration. That is, the user saves the reference signature produced while the circuit is in the reference-defining mode.

Next, at step 762, the user can optionally put other circuits, that are configured in the same way as the one referred to with reference to step 761, into a reference-defining mode. The user can then check that the reference signature is the same for each circuit because any differences between the reference signatures can be indicative of a fault in one or more of the circuits.

Once the application (for example an electric vehicle) has left the user's lab and is in active use, the user / application software may occasionally perform a self-test (in the self-testing mode). For example, a self-test can be triggered by application software in response to: a threshold number of sleep to active transitions of the circuit being reached; and / or a predetermined duration since the last self-test elapsing. The self-test is initiated at step 771, and it produces a test signature. After the test signature is produced by this self-test, the test signature is compared with the saved reference signature at step 772. If the test signature matches the reference signature, then the test signal indicates a passed test, as shown by step 773. If the test signature does not match the reference signature, then the test signal indicates a failed test, as shown by step 774.

If the test signature indicates a failed test, then a remedial action can automatically be taken. This action can set the system into a fail-safe mode, e.g. it may include disconnecting potentially hazardous components, initiating a diagnostic test or any other suitable action in response to the discovery of an error in a system. If the test signature indicates a passed test, then no action need be taken and the system may continue normal operation. In some examples, an action can be taken if the test signature indicates a passed test, for example saving a record of the test and the result, notifying the user or any other suitable action in response to the non-discovery of an error in a system.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An electronic circuit for performing a self-test, the electronic circuit comprising:

   a first circuit which comprises:

   a first configuration register configured to define functions which are settable by a user,
   a first event processor,
   a first signal generator, and
   a first signature generator;

   a second circuit which comprises:

   a second configuration register configured to define the same functions as the first configuration register,
   a second event processor,
   a second signal generator, and
   a second signature generator; and

   a comparison block;

   wherein:

   during a reference-defining mode of the electronic circuit:

   the first signal generator is configured to provide a checking signal as an input signal to the first event processor,
   the first event processor is configured to generate an output signal based on the checking signal and the functions defined by the first configuration register, and
   the first signature generator is configured to generate a reference signature based on the output signal from the first event processor; and

   during a self-testing mode of the electronic circuit:

   the second signal generator is configured to provide the checking signal as an input signal to the second event processor,

the second event processor is configured to generate an output signal based on the checking signal and the functions defined by the second configuration register, and the second signature generator is configured to generate a test signature based on the output signal from the second event processor; and

the comparison block is configured to compare the test signature to the reference signature in order to provide a test result signal.

2. The electronic circuit of claim 1, comprising a common configuration register, wherein the common configuration register is configured to perform the functionality of both the first configuration register and the second configuration register, thereby defining the functions for both the first and second event processors.

3. The electronic circuit of claim 2, comprising:

a common event processor configured to perform the functionality of both the first event processor and the second event processor;
a common signal generator configured to perform the functionality of both the first signal generator and the second signal generator;
a common configuration register configured to perform the functionality of both the first signature generator and the second signature generator.

4. The electronic circuit of claim 1, wherein:

the second event processor is a different component to the first event processor;
the second signal generator is a different component to the first signal generator; and
the second signature generator is a different component to the first signature generator.

5. The electronic circuit of any preceding claim, wherein the reference-defining mode of the electronic circuit is implemented during a first time period and the self-testing mode of the electronic circuit is implemented during a second time period, wherein the second time period is after the first time period.

6. The electronic circuit of claim 4, wherein the reference-defining mode of the electronic circuit is implemented during a first time period, and the self-testing mode of the electronic circuit is implemented during a second time period, wherein the first time period overlaps with the second time period.

7. The electronic circuit of any preceding claim, further comprising a finite state machine configured to:

initiate the reference-defining mode of the electronic circuit by providing a reference-defining initiation signal to:
the first signal generator, the second signal generator, the first event processor, the second event processor, the first signature generator, and the second signature generator; and
initiate the self-testing mode of the electronic circuit by providing a self-testing initiation signal to:
the first signal generator, the second signal generator, the first event processor, the second event processor, the first signature generator, and the second signature generator.

8. The electronic circuit of claim 7, wherein in response to receiving either: i) the reference-defining initiation signal, or ii) the self-test initiation signal, from the finite state machine:
the first signal generator, the second signal generator, the first event processor, the second event processor, the first signature generator, and the second signature generator are configured to be reset.

9. The electronic circuit of claim 8, wherein the first signal generator and the second signal generator are configured to provide a pseudo-random checking signal, such that the pseudo-random checking signal is the same for each reference-setting mode of the electronic circuit and each self-test mode of the electronic circuit.

10. The electronic circuit of claim 8 or 9 wherein the finite state machine is configured to initiate a normal-operation mode of the electronic circuit by providing a normal-operation initiation signal after the reference-defining mode and / or the self-testing mode, wherein during a normal-operation mode of the electronic circuit:

the first signal generator is configured to operate as an input register configured to provide data-bus signals from a first data bus as input signals to the first event processor, and
the second signal generator is configured to operate as an input register configured to provide data-bus signals from a second data bus as input signals to the second event processor.

11. The electronic circuit of claim 10, wherein the finite state machine is configured to provide a reference-defining initiation signal, a self-test initiation signal or a normal-operation initiation signal, based on a user input.

12. The electronic circuit of any preceding claim, wherein:

the electronic circuit further comprises:

a fuse; and
a fuse-breaking circuit;

the test result signal is configured to indicate: i) a passed test if the test signature matches the reference signature; or ii) a failed test if the test signature does not match the reference signature; and
the electronic circuit is configured to take remedial action if the test result signal indicates a failed test.

13. The electronic circuit of claim 12, wherein the fuse and the fuse-breaking circuit comprises a pyro-fuse.

14. The electronic circuit of any preceding claim, wherein the electronic circuit is implemented on an integrated circuit.

# Figure 1

# Figure 2

EP 4 660 642 A1

# Figure 3

# Figure 4

420

# Figure 5

EP 4 660 642 A1

# Figure 6

EP 4 660 642 A1

# Figure 7

760

761

Customer saves the result key for a given configuration

762

Customer tests on different parts that the key is always the same

770

771

Time to time customer runs the test

772

Customer compares the key with the expected

Are different

774

Test signal indicates a failed test

Are the same

773

Test signal indicates a passed test

Europäisches
Patentamt

European
Patent Office

Office européen
des brevets

# EUROPEAN SEARCH REPORT

**Application Number**

EP 24 30 5901

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/011537 A1 (KIRYU NAOKI [JP]) 11 January 2007 (2007-01-11) * abstract; claims 1-20; figures 1-6 * * paragraph [0013] - paragraph [0018] * * paragraph [0029] - paragraph [0065] * | 1-14 | INV. G01R31/3185 G01R31/3187 G01R31/317 G06F11/27 G06F11/22 |
| X | US 2022/178996 A1 (DOUSKEY STEVEN MICHAEL [US] ET AL) 9 June 2022 (2022-06-09) * abstract; claims 1-20; figures 1-9 * * paragraph [0002] * * paragraph [0012] - paragraph [0061] * | 1-14 | |
| X | US 2013/212441 A1 (VILELA ANTONIO [DE] ET AL) 15 August 2013 (2013-08-15) * abstract; claims 1-38; figures 1-6 * * paragraph [0007] - paragraph [0008] * * paragraph [0015] - paragraph [0066] * | 1-14 | |
| X | US 2011/296266 A1 (SONG PEILIN [US] ET AL) 1 December 2011 (2011-12-01) * abstract; claims 1-24; figures 1-8 * * paragraph [0007] - paragraph [0009] * * paragraph [0020] - paragraph [0043] * | 1-14 | TECHNICAL FIELDS SEARCHED (IPC) G01R G06F |
| X | US 2017/192053 A1 (JACQUET DAVID [FR] ET AL) 6 July 2017 (2017-07-06) * abstract; claims 1-18; figures 1,2 * * paragraph [0007] - paragraph [0010] * * paragraph [0018] - paragraph [0033] * | 1-14 | |
| X | US 7 007 211 B1 (WHITE CHRISTOPHER E [US] ET AL) 28 February 2006 (2006-02-28) * abstract; claims 1-18; figures 1-5 * * column 1, line 20 - line 55 * * column 2, line 15 - column 7, line 27 * | 1-14 | |

The present search report has been drawn up for all claims

| Place of search | Date of completion of the search | Examiner |
|---|---|---|
| Munich | 22 November 2024 | Nadal, Rafael |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

                                                          
& : member of the same patent family, corresponding document

EPO FORM 1503 03.82 (P04C01)

**EP 4 660 642 A1**

## ANNEX TO THE EUROPEAN SEARCH REPORT
## ON EUROPEAN PATENT APPLICATION NO.

EP 24 30 5901

This annex lists the patent family members relating to the patent documents cited in  the above-mentioned European search report.
The members are as contained in the European Patent Office EDP file on
The European Patent Office is in no way liable for these particulars which are merely given for the purpose of information.

22-11-2024

| Patent document cited in search report | | Publication date | Patent family member(s) | | Publication date |
|---|---|---|---|---|---|
| US 2007011537 | A1 | 11-01-2007 | NONE | | |
| US 2022178996 | A1 | 09-06-2022 | CN | 114625583 A | 14-06-2022 |
| | | | DE | 102021128930 A1 | 09-06-2022 |
| | | | GB | 2604975 A | 21-09-2022 |
| | | | JP | 2022091131 A | 20-06-2022 |
| | | | US | 2022178996 A1 | 09-06-2022 |
| US 2013212441 | A1 | 15-08-2013 | CN | 103294049 A | 11-09-2013 |
| | | | KR | 20130094249 A | 23-08-2013 |
| | | | US | 2013212441 A1 | 15-08-2013 |
| | | | US | 2013212452 A1 | 15-08-2013 |
| US 2011296266 | A1 | 01-12-2011 | NONE | | |
| US 2017192053 | A1 | 06-07-2017 | CN | 106932707 A | 07-07-2017 |
| | | | EP | 3190424 A1 | 12-07-2017 |
| | | | US | 2017192053 A1 | 06-07-2017 |
| US 7007211 | B1 | 28-02-2006 | US | 7007211 B1 | 28-02-2006 |
| | | | US | 7490276 B1 | 10-02-2009 |

EPO FORM P0459

For more details about this annex : see Official Journal of the European Patent Office, No. 12/82

22